(19) Europäisches Patentamt
European Patent Office
Office européen des brevets

(11)     **EP 1 361 453 B1**

(12)     **EUROPEAN PATENT SPECIFICATION**

(45) Date of publication and mention
of the grant of the patent:
**02.06.2010   Bulletin 2010/22**

(51) Int Cl.:
*G01R 33/38* *(2006.01)*

(21) Application number: **03009775.2**

(22) Date of filing: **08.05.2003**

(54) **Nmr magnet device for solution analysis and nmr apparatus**

NMR-Magnet für Lösungsanalyse und NMR-Gerät

Aimant de RMN pour analyse de solutions et appareil de RMN

(84) Designated Contracting States:
**CH DE GB LI**

(30) Priority: **08.05.2002   JP 2002132255**

(43) Date of publication of application:
**12.11.2003   Bulletin 2003/46**

(73) Proprietor: **Hitachi, Ltd.**
**Chiyoda-ku,**
**Tokyo (JP)**

(72) Inventors:
• **Kakugawa, Shigeru**
**Hitachi-shi,**
**Ibaraki 319-1416 (JP)**
• **Okada, Michiya**
**Ibaraki 311-1134 (JP)**
• **Aihara, Katsuzou**
**Ibaraki 313-0022 (JP)**
• **Morita, Hiroshi**
**Hitachi-shi,**
**Ibaraki 316-0025 (JP)**
• **Wakuda, Tsuyoshi**
**Hitachi-shi,**
**Ibaraki 316-0025 (JP)**

(74) Representative: **Beetz & Partner**
**Patentanwälte**
**Steinsdorfstrasse 10**
**80538 München (DE)**

(56) References cited:
**EP-A- 0 488 464     EP-A- 1 004 887**
**US-B1- 6 215 384**

• **PATENT ABSTRACTS OF JAPAN vol. 2002, no. 06, 4 June 2002 (2002-06-04) & JP 2002 043116 A (KOBE STEEL LTD), 8 February 2002 (2002-02-08)**

**EP 1 361 453 B1**

## Description

Background of the Invention

The present invention relates to a nuclear magnetic resonance analyzing apparatus and, particularly, to a split-type magnet device for generating a uniform magnetic field.

Rapid progress has recently been made in the field of organic analysis using the nuclear magnetic resonance. In particular, atomic structures of organic compounds such as proteins can now be efficiently analyzed by the combined use of the nuclear magnetic resonance and the superconducting ferromagnetic technology. An object of the present invention is to provide a magnet device for an NMR spectrometer which is suitable for analyzing atomic structures and interactions of protein molecules in a solution (the solution is prepared by dissolving minute amounts of proteins in a liquid). An NMR spectrometer is a special energy spectrometer which is different from a medical MRI diagnosing apparatus having an image resolution of millimeter order to be used for human tomography. Such a special energy spectrometer must have a magnetic field intensity which is higher than that of the medical MRI diagnosing apparatus by one digit, a magnetic field uniformity which is higher than that of the medical MRI diagnosing apparatus by four digits, and a stability which is higher than that of the medical MRI diagnosing apparatus by three digits, and design engineering and manufacturing technology thereof are totally different from those of the medical MRI diagnosing apparatus. Details of the conventional high-resolution nuclear magnetic resonance analyzing apparatuses can be found in "NMR of Proteins" written by Yohji Arata and published by Kyoritsu Shuppan in 1996. Recent inventions relating to typical equipment components to be utilized for applying NMR to the protein analysis includeJP 2000-147082 A, which discloses an invention relating to the superconducting magnet, i.e., multilayer air-core solenoid coils; US 6 121 776 which discloses a birdcage superconducting detection coil; JP 2000-266830 A and JP 6-237912 A which disclose a signal detection technique using a conventional saddle-like coil or a birdcage coil. According to the above patent literature, all of the conventional high sensitivity nuclear magnetic resonance analyzing apparatus for protein analysis include a superconducting magnet device comprising combined solenoid coils which generate a magnetic field in a vertical direction, thereby irradiating a sample with electromagnetic waves of 400 to 900 MHz to detect the resonance waveform produced from the sample by the use of the saddle-like or the birdcage detection coil. In some cases, the S/N ratio is improved by the use of a detector which is cooled to a low temperature in order to reduce the thermal noise in the detection of signals as disclosed in the above-mentioned Patent US 6 121 776.

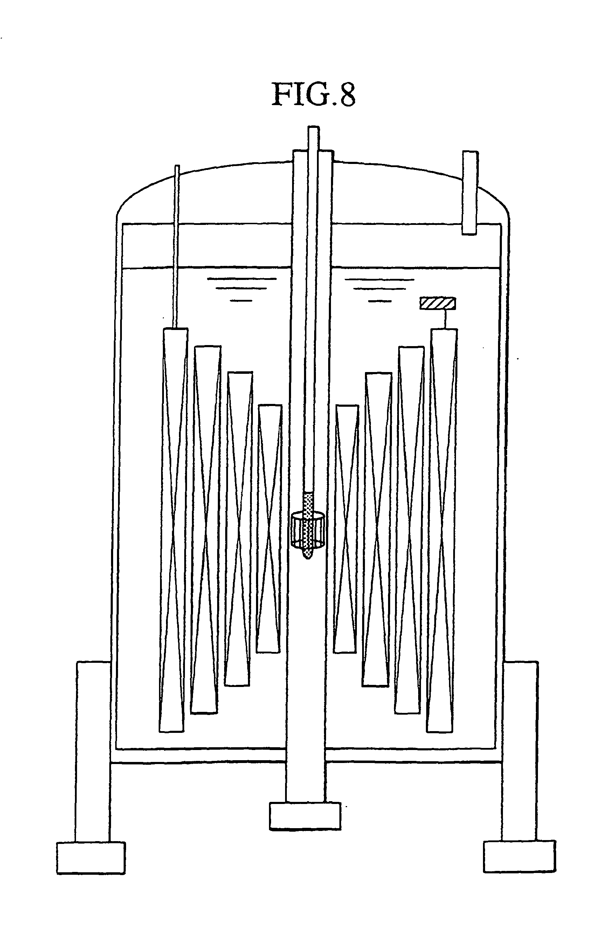

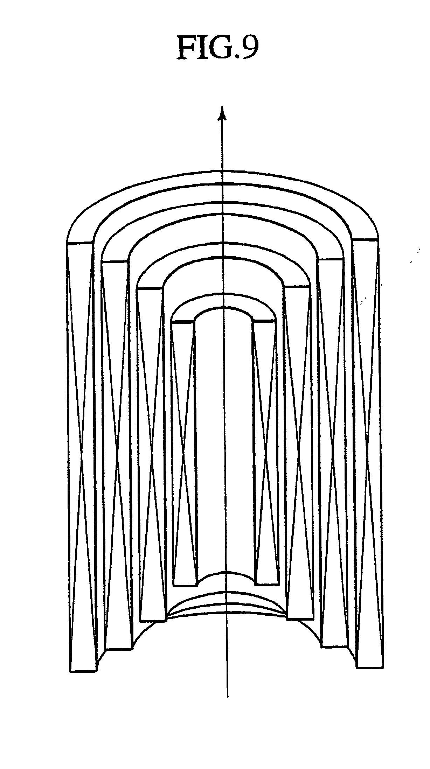

In the past, the sensitivity of the high sensitivity nuclear magnetic resonance apparatus has been improved by applying methods of improving the intensity at the center portion of the magnetic field of the superconducting magnet without changing the basic system structure of the apparatus including an antenna, a magnet, and so forth. Therefore, although the maximum NMR detection sensitivity which has heretofore been reported was achieved by an NMR apparatus of 900 MHz comprising a large superconducting magnet as shown in Fig. 8 having a center magnetic field intensity of 21.1 T (Tesla), the basic structure of the NMR apparatus is not any different from that of the prior art disclosed in JP 2000-147082 A. For a better understanding of the basic structure, a sectional perspective view of the superconducting coils of the NMR apparatus is shown in Fig. 9 wherein a virtual central axis is indicated (arrow). In the protein analysis using solutions, the increase in the intensity at the magnetic field center has the effects of improving the sensitivity and clarifying the separation of the chemical shift.

The sensitivity improving effects depending on the shape of the detection coils are mentioned in page 326 of "Book of NMR", written by Yohji Arata and published by Maruzen in 2000, where the solenoid coil is advantageous as compared with the saddle-like coil or the birdcage coil in various aspects as described below.

For example, the solenoid coil is superior in control lability of impedance, filing factor, and RF magnetic field efficiency. According to the "Book of NMR", however, it is actually impossible to wind solenoid coils around a sample tube which is placed perpendicularly with respect to the magnetic field in the conventional superconducting magnet structure and, in general, the solenoid coil has not been used in cases where the sensitivity is crucial such as the case of determining a minute amount of protein dissolved in a solution.

Further, the use of a superconducting birdcage antenna for the reduction of the thermal noise has recently been proposed. For the particularly exceptional case wherein the solenoid coil is used for determining a minute amount of a sample in solution with high sensitivity, a method which employs a specially designed microsample tube and probe combined with the solenoid coil is known.

As a particular example, a method wherein a high-temperature superconducting bulk magnet is magnetized in the horizontal direction to detect NMR signals using a solenoid coil is disclosed in JP 11-248810 A. JP 7-240310 A discloses structures of a superconducting magnet and a cooling container suitably used for a typical NMR for eliminating the restriction in the height of the apparatus.

EP 1 004 887 A discloses an open magnet device for magnetic resonance imaging (MRI) applications, and does not relate to a magnet device for NMR spectrometers. The open magnet device of this prior art comprises two mirror-symmetrical superconductive coil assemblies having a common horizontal axis and producing a horizontal magnetic field, each of the coil assemblies comprising at least one main coil and at least one shielding coil arranged side by side in axial direction, with a magnetizable member interposed therebetween. A pole piece is provided in each of the two coil assemblies radially inside the main and shielding coils. The current in the shielding coils is in a direction opposite to that of the main coils.

JP 2002 043116 A discloses a superconductive magnet device for an NMR apparatus, ESR apparatus, and other physical research devices. The magnet device is composed of three concentric, coaxial coils. The outermost coil is relatively movable in the axial direction of the magnet device with respect to the other, radially inner coils by the electromagnetic force acting in the axial direction. This leads to a reduction of the intensity of the magnetic field in the center space of the magnet device and to an improvement of the magnetic field uniformity.

However, a method of achieving the detection sensitivity, and techniques of controlling the uniformity and the time stability of the magnetic field required for analyzing proteins have not yet been proposed.

Recently, the need for the analysis of samples which contain proteins each having a low solubility in liquids has grown with the increase in the need for investigations of proteins, and such growing need has brought about the necessity of improving the sensitivity for detecting NMR spectra. In order to adapt a nuclear magnetic resonance analyzing apparatus for the needs described above, it is necessary to improve the detection sensitivity without increasing the size of the sample space as compared with conventional apparatus and, further, it is mandatory to provide stability of the magnetic field of a superconducting magnet for a long period of data integration time. The improved sensitivity contributes not only to the reduction in the detection time but also to the reduction in the sample amount, thereby achieving the effect of enabling the analysis of proteins having a low solubility in liquids. Thus, it is required that the NMR analyzing apparatus to be used for the protein analysis have particularly superior detection sensitivity and stability as compared with the conventional ones, and accurate and stable NMR signal detection over a long period of time such as a week or more must be assured. This is because a fluctuation in the magnetic field during the detection causes a peak of NMR signals to move, and such movement of a peak in the detection of interaction can lead to the confusion that the movement of a peak may be caused by the interaction or by an unstable magnetic field. Further, if the magnetic field is non-uniform, desired peaks may overlap to cause problems such as difficulty in distinguishing the interaction. Thus, the future NMR technology used for the purpose of analyzing proteins must be a novel technology which is not a simple modification of conventional NMR apparatus.

For example, specifications for the uniformity of a magnetic field provided in a typical NMR apparatus are 0.01 ppm in the sample space and 0.01 ppm/h by time stability. If this magnetic field is used in a typical proton NMR of 600 MHz, the allowable error is 6 Hz.

However, for the analysis of interactions of proteins, the time resolution is required to be not more than 1.0 Hz, preferably not more than 0.5 Hz.

The superconducting magnet and the detection coil must be optimized so as to achieve the above-identified uniformity and time stability of the magnetic field. Therefore, the performances of the conventional NMR apparatuss are insufficient, and the required stability and uniformity are greater than those achieved by the conventional NMR apparatus by one digit or more.

Since the improvements in the sensitivity of the conventional NMR apparatus have been achieved by intensifying the magnetic field, the apparatus have become too large. Since a dedicated room was required for the apparatus in view of the leakage magnetic field and the floor strength, problems such as poor installability have arisen. Also, the increase in the cost because of the superconducting magnet has been problematic. Further, in the improvement in the sensitivity by the conventional technique, the intensity has reached its upper limit of 21 T due to the restriction caused by the critical magnetic field of the superconducting material. Therefore, in order to achieve a further improvement of sensitivity, there has been a demand for a new technique of improving the detection sensitivity which does not rely on the magnetic field intensity.

High-sensitivity detection using the solenoid coil can be realized by the use of the special sample tube which contains a minute amount of a sample and the special detection probe as mentioned above; however, the high-sensitivity detection method is not suitable for analyzing a protein solution of as little as about 10 ml. Further, according to a prior art, wherein a magnetic field is generated in the horizontal direction by the use of a ferromagnetic member, and NMR signals are detected by the use of the solenoid coil, which is disclosed in JP 11-248810 A, a magnetic field of less than 10 T is generated on the surface of the high temperature superconductor, while the magnetic field near the sample has an intensity of several Tesla at most. Therefore, it is impossible to achieve a magnetic field of 11 T or more, preferably 14.1 T or more, which is required for the protein analysis in a desired sample space, through the use of the device disclosed in JP 11-248810 A.

Further, the apparatus disclosed in JP 11-248810 A involves difficulties in achieving a time stability of 1.0 Hz/time or less, which is required for the protein analysis, due to the magnetic flux creep of the superconductors. Further, this apparatus also involves difficulties in achieving a magnetic field uniformity of 1.0 Hz or less of the proton nuclear magnetic resonance frequency, which is required for the protein analysis, in a space having a diameter of 10 mm and a length of 20 mm, since there is a non-uniformity originating from the manufacturing process of the material of the superconducting bulk magnet.

Thus, developments in break-through technology to fit the needs for the protein analysis are in demand, while the improvement in sensitivity achieved by increasing the magnetic field intensity has reached the ceiling. Therefore, a novel technique for the improvement in sensitivity has been in demand.

To provide an efficient, accurate analysis of interactions of proteins with low molecular weight molecules such as a substrate and ligand in a solution, for which there is a growing demand, it is desirable that the analysis be conducted by using an appropriate amount of sample with a frequency of 600 to 900 MHz and an intensity at the magnetic field center of about 14 to 21 T, and that detection sensitivity and throughput be increased.

In general, in an apparatus of 800 MHz or more, liquid helium of 4.2 K is depressurized and supercooled to 1.8 K in order to exploit the superconductivity to the utmost. Therefore, the operation of the apparatus is complicated, and a very careful maintenance is necessary therefor.

Further, since the leakage magnetic field is increased with the increase in the size of the magnetic device, a dedicated room is usually required for the conventional NMR apparatus. In particular, from the standpoint of the installability of the apparatus, the conventional magnetic device has the problem of magnetic field leakage which is increased in the vertical direction with the increase in the intensity at the magnetic field center. For example, since the conventional class 900 MHz magnet device generates a leakage magnetic field as long as 5 m in height, a room having a considerable ceiling height is required.

Thus, the conventional magnet device has the problem of increased cost for installation. In addition, the magnet portion of the conventional 900 MHz superconducting magnet has a diameter of 1.86 m and a height of several meters as is disclosed in "IEEE. Transactions on Applied Superconductivity", Vol. 11, No. 1, p. 2438.

It is the problem underlying the present invention to provide a magnet device and an NMR apparatus, particularly for the analysis of solutions, in particular protein solutions, which overcome the above-described problems of the prior art devices.

An object of the present invention is to provide a novel nuclear magnetic resonance analyzing apparatus in which the detection sensitivity of NMR signals is improved by 40% or more at a frequency of 600 MHz (14.1 T) with respect to the conventional apparatus in a state where an ordinary sample tube having a diameter of 5 to 10 mm and containing a sample solution of 30 mm in height is placed therein and in which a time stability and a space uniformity of the superconducting magnet required for the protein analysis are provided.

The above problems are solved in accordance with the independent claims. The dependent claims relate to preferred embodiment of the concept of the present invention.

The split-type magnet device for NMR spectrometers of the present invention

- comprises a first set of superconductor coil elements and a second set of superconductor coil elements , wherein
- the coil elements of the first set of coil elements and the coil elements of the second set of coil elements

  • each comprise at least one coil,
  • are arranged radially outward and substantially coaxially with respect to a central axis which extends along a substantially horizontal direction,
  • are arranged substantially mirror-symmetrically to one another with respect to a centerplane extending along the vertical direction of the magnet device and face each other with a predetermined distance to form a sample space therebetween, and
  • are provided to generate a horizontal magnetic field,

- the sample space between the first set of coil elements and the second set of coil elements is provided for placing a tube for a sample in a vertical position at the center portion of the magnetic field and for placing a solenoid probe coil around the tube for the sample,
  and
- the direction of the magnetic field generated by the innermost coil element of the first set of coil elements and the innermost coil element of the second set of coil elements is reverse to the direction of the main magnetic field generated by the other coil elements of the first set and the other coil elements of the second set of coil elements in the vicinity of the center portion of the magnet device.

The NMR spectrometer of the present invention comprises the magnet device of the invention.

The present invention shall not be intended to limit the operation temperature to 4.2 K in structure. It is possible to realize the ultimate performance through the application of the present invention and, depending on the mode of the application, the apparatus of the present invention may be operated with the conventional upper limit magnetic field intensity of 21.1 T, i.e., 900 MHz and 1.8 K.In this case, the apparatus of the present invention permits to improve the sensitivity by 40% as compared with the conventional apparatuses, thereby advancing the upper limit of the detection sensitivity for the first time in the art.

The inventors of the present invention have conducted intensive studies to find out the problems of the conventional nuclear magnetic resonance apparatuses and solutions thereto. Since the existing nuclear magnetic resonance apparatus have been developed from the standpoint of both cost and installability, NMR signals produced from a solution sample placed at the center portion of multilayer air-core solenoid coils having an excellent magnetic field uniformity have been detected by the use of a saddle-like or birdcage antenna. In the past, with the development in the NMR technology attained by the progresses in detection techniques and analysis methods, the detection sensitivity has been improved through the enhancement of the intensity at the magnetic field center from a magnetic field intensity for less than 400 MHz without changing the basic structure. The inventors have conducted intensive studies on a technique for remarkably enhancing the signal intensity without changing the magnetic field intensity. As a result, it has been found that the novel structure described above can solve the problems described above.

The invention enables the improvement in sensitivity by using a solenoid detection coil preferably having a diameter of about 5 to 10 mm and a height of about 20 mm, with which an ordinary sample tube for NMR investigations can be used, in a sample space having a diameter of 5 to 10 mm and in a magnetic field corresponding to not less than 400 MHz, preferably about 600 to 900 MHz, which is suitable for NMR analysis of solutions of a height of 20 mm.

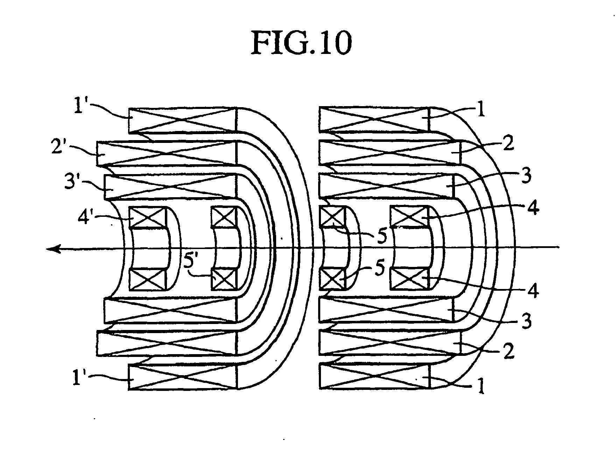

In theory, it is expected that a sensitivity of 1.4 ($\sqrt{2}$) times that achieved by the conventional devices is achieved by the shape of the coil, and further improvement is expected by other factors. Also, the data integration time can be shortened to not more than half that of the conventional devices. The sample tube having a diameter of 5 to 10 mm is charged with a liquid sample until it reaches a height of 20 to 30 mm and inserted into the apparatus from above along the vertical direction. In order to detect the NMR signals with high sensitivity by the solenoid coil which is wound about a vertical axis, it is necessary to establish a magnetic field to be generated by the superconducting magnet in the horizontal direction and to make it possible to place the sample tube with the solution sample, which can readily be attached and removed, at the center portion of the magnetic field. Therefore, the structure of the superconducting magnet device of the present invention is different from that of the conventional devices which use a simple solenoid magnet, and thereby it is necessary that the superconducting magnet be a split-type magnet having a pair of left and right magnets. It is necessary that the magnet to be used for the NMR apparatus generates a magnetic field of ppb-order uniformity in the sample space as mentioned above. A technique for achieving the uniformity of the magnetic field using the high magnetic field split-type magnet of 14.1 T has not been proposed in the art. As shown in Fig. 10. the present invention is characterized in that the current conveyed by coils constituting the innermost layer, i.e. coil elements, among two sets of multilayer coils, i.e. two sets of coaxial and radially arranged coil elements, facing each other with a predetermined distance flows in a direction reverse from that of the main magnetic field.

Brief Description of the Drawings

Other objects and advantages of the invention will become apparent from the following description of embodiments with reference to the accompanying drawings in which:

Fig. 1 is a sectional view schematically showing an NMR apparatus according to a first embodiment of the present invention;

Fig. 2 is a sectional view showing the arrangement of coils of a split-type magnet device according to a second embodiment of the present invention;

Fig. 3 is a sectional view showing the arrangement of coils of a split-type magnet device according to a third embodiment of the present invention;

Fig. 4 is a sectional view showing the arrangement of coils of a split-type magnet device according to a fourth embodiment of the present invention;

Fig. 5 is a sectional view showing the arrangement of coils of a split-type magnet device and a ferromagnetic member for shielding leakage magnetic field according to a fifth embodiment of the present invention;

Fig. 6 is a sectional view showing the arrangement of coils of a split-type magnet device and a ferromagnetic member for shielding leakage magnetic field according to a sixth embodiment of the present invention;

Fig. 7 is a sectional view showing an arrangement of coils of a split type magnet device and a ferromagnetic member for shielding leakage magnetic field according to a seventh embodiment of the present invention;

Fig. 8 is a sectional view schematically showing a conventional NMR apparatus;

Fig. 9 is a sectional perspective view showing superconducting coils constituting the magnets of a conventional NMR apparatus;

Fig. 10 is a sectional perspective view showing coils of a split-type magnet device according to another embodiment of the present invention;

Fig. 11 is a schematic perspective view showing the NMR apparatus of the present invention;

Fig. 12 is a diagram for the purpose of explaining an effect of the present invention, showing a two-dimensional axisymmetrical distribution of currents;

Fig. 13 is a diagram for the purpose of explaining an effect of the present invention, schematically showing the positional relationship between the current I which is represented by the position $(f,\alpha)$ and $r,\theta$;

Fig. 14 is a diagram showing, for the purpose of explaining an effect of the present invention, the relationship between a second-order irregular magnetic field generated by the current I which is represented by the position $(f,\alpha)$ and the angle $\alpha$;

Fig. 15 is a diagram showing, for the purpose of explaining an effect of the present invention, the relationship between a fourth-order irregular magnetic field generated by the current I which is represented by the position $(f,\alpha)$ and the angle $\alpha$; and

Fig. 16 is a diagram showing, for the purpose of explaining an effect of the present invention, the relationship between a sixth-order irregular magnetic field generated by the current I which is represented by the position $(f,\alpha)$ and the angle $\alpha$.

Referring to Fig. 10, the arrow indicated in Fig. 10 is the virtual central axis of coils 1 to 5 and 1' to 5' constituting the magnet. Since each of the coils is wound around a spool, which is not shown in Fig. 10, the section thereof typically has a substantially rectangular shape as shown in Fig. 10. Also, in order to facilitate the fabrication of the magnet, it is desirable to reduce the number of spools. Therefore, as the coils 4 and 5, 4' 5' of Fig. 10, coils having a substantially identical inner diameter are usually wound around an identical spool. In the present invention, the coils such as the coils 4 and 5, 4' and 5' which have the substantially identical inner diameter, a substantially identical central radius or a substantially identical outer diameter as seen in their sectional views are referred to as coils forming an identical layer.

In order to generate a uniform magnetic field at the central part of the magnet where a sample is inserted, it is necessary to use the coils which generate a magnetic field in a direction reverse from that of the main magnetic field as the innermost coils constituting the innermost layer in the split-type magnet of the present invention. The reasons for such necessity will hereinafter be explained.

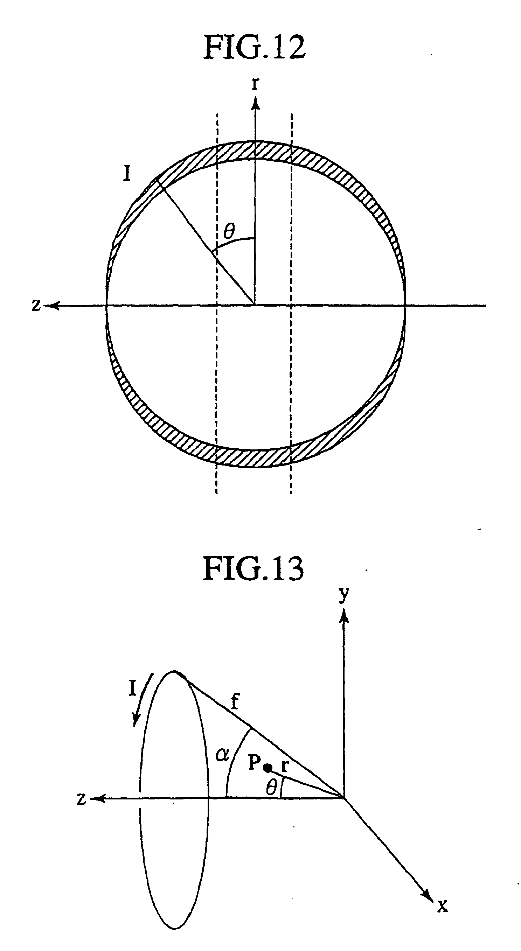

Fig. 12 is a sectional view showing a two-dimensional axisymmetrical distribution of currents. As is well-known, the uniform magnetic field is generated in the inner space of the current distribution by setting the current $I(\theta)$ depending on an angle $\theta$ when the center axis is the z axis to be a so-called cosine $\theta$ distribution as represented by the following expression:

$$I(\theta) = A \cdot \cos(\theta).$$

In the above expression, A is a proportional constant.

Generation of the uniform magnetic field by the use of a limited number of coils means discretization of the current distribution shown in Fig. 12. However, as it can be understood qualitatively, it is difficult to discretize the currents in a region between the two dotted lines of Fig. 12 outside the region through the discretization of the unidirectional current distribution of Fig. 12 using the split-type coils.

It is possible to overcome that difficulty by using expressions for the magnetic field generated by an annulus current as follows. It is possible to represent the z component of a magnetic field which is generated at the point P (r , θ) in the inner region of a sphere formed by inscribing the annulus current I to the annulus ring as shown in Fig. 13 by the following expressions:

$$B_z = \sum_{n=0}^{\infty} A_n r^n P_n (\cos \theta)$$

$$A_n = \frac{\mu_0 I}{2f^{n+1}} \sin \alpha \, P_{n+1}^1 (\cos \alpha)$$

In the above expressions, $A_n$ represents the intensity of the n-th order magnetic field,

P    is the location of the observation point as indicated in Fig. 13;

r    is the distance from the origin to the observation point;

θ    is the zenith angle position of the observation point;

$\mu_0$    is the magnetic permeability in vacuum;

I    is the circular current;

f    is the distance from the origin to the circular current;

α    is the zenith angle position of the circular current I;

$P_n^m (x)$    is the Legendre function, and

$P_a(x)$    is the associated Legendre function.

An nth-order magnetic field comprises magnetic field components of orders 0, 1, 2, .... Their corresponding strength is proportional to the nth power of r.

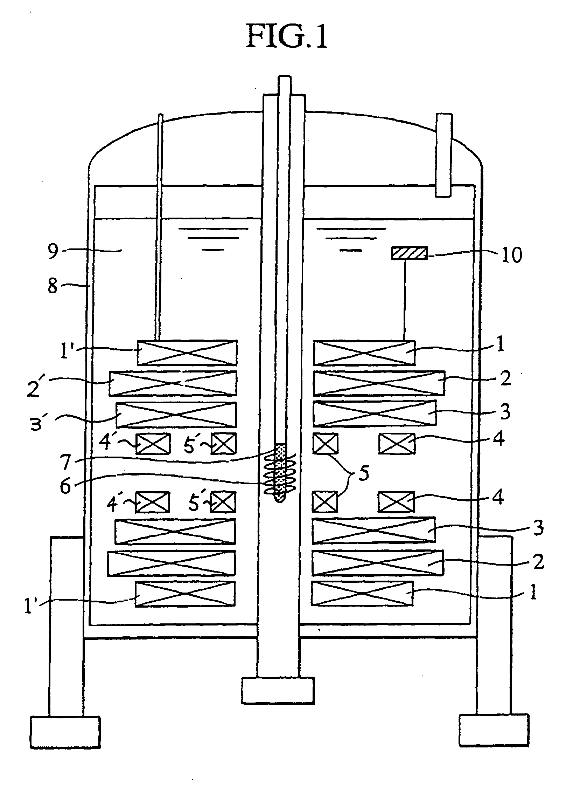

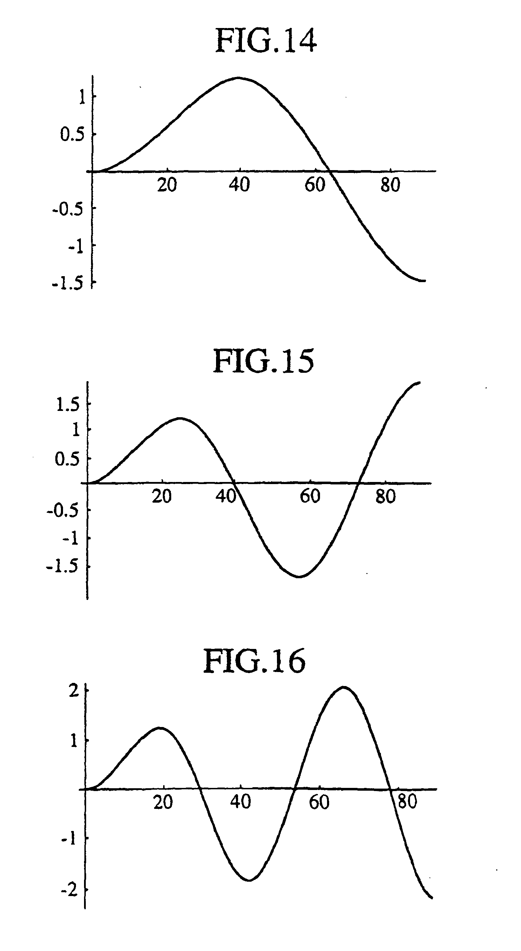

Since the magnet of the present invention is mirror-symmetrical with respect to the center plane, only the even-order magnetic fields (field components) are to be considered due to the symmetry. It is possible to generate the uniform magnetic field by setting the sum of the second-order irregular magnetic fields to zero. Shown in Figs. 14 to 16 are graphs in each of which the magnetic field intensity ($A_2$, $A_4$, and $A_6$, respectively) is plotted with respect to $\alpha$. In the graphs, it is defined that $\mu_0 I/2f^{n+1} = 1$. As shown in Figs. 15 and 16, since each of the higher-order magnetic fields takes positive and negative values with respect to $\alpha$, the sum of the magnetic fields of all the coils can readily be set to zero if the arrangement and the magnetomotive forces of the discrete coils are properly set. In turn, the second-order magnetic field shown in Fig. 14 becomes zero when $\tan\alpha = 2$. This position is well-known as that of a Helmholtz coil. As is apparent from Fig. 14, when $\alpha$ is smaller than the $\alpha$ of $\tan\alpha = 2$ (about 63.4 degree), the second magnetic field takes only a positive value. As is apparent from Figs. 1, 2, and 10, since almost all of the coils are placed at positions where $\alpha$ is smaller than the above-described $\alpha$ (about 63.4 degrees) in the split-type coil arrangement, it is impossible to set the total of second-order irregular magnetic fields generated by the coils having a current in the direction (positive direction) identical with that generating the main magnetic field to zero. Therefore, it is necessary to use coils having a current in the direction reverse (negative direction) to that generating the main magnetic field, and it is desirable that the portion at which the coils are to be arranged be such that the radius of each of these coils is smaller than those of other coils, i.e. they are the innermost coils. Reasons for the desired arrangement will hereinafter be explained. The intensity of an irregular magnetic field generated by the annulus current I shown in Fig. 13 is inversely proportional to $f^{n+1}$ according to the above-indicated expressions. Therefore, a smaller radius of the annulus current is more advantageous for generating $A_o$, i.e., a negative second-order irregular magnetic field, without impairing the intensity of the main magnetic field. In principle, it is possible to set the second-order irregular magnetic field to zero by the use of negative current coils having a large radius: however, in view of the above reasons, such negative current coils are unrealistic as to be used for making up a high magnetic field generating magnet, which is the subject of the present invention, since they reduce the intensity of the main magnetic field. In view of the above reasons, the negative-direction current coils are necessarily used for the coils forming the innermost layer, i.e., the innermost coils having an inner diameter, a central radius or an outer diameter as seen in their sectional views.

Detailed Description of the Preferred Embodiments

Specific embodiments of the present invention will hereinafter be described.

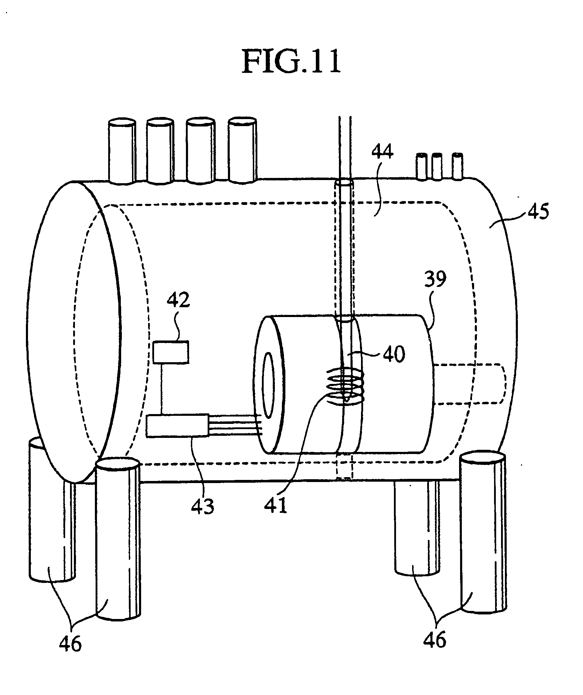

Fig. 11 is a schematic diagram showing an NMR apparatus using a split-type magnet. A superconducting magnet 39 formed of split coils is installed with the virtual central axis thereof extending along a substantially horizontal direction. A sample 40, for example a protein sample, is inserted into the apparatus from above, and a uniform static magnetic field is applied in the horizontal direction to the sample 40. Since a solenoid coil 41 is used for receiving the NMR signals, the S/N ratio is improved by 40% as compared with that achieved by the conventional method wherein a saddle-like or birdcage solenoid coil is used as mentioned in the foregoing. The super-conducting magnet 39 is maintained at a permanent current mode by using a permanent current switch 42. The coils constituting the super-conducting magnet 39 are connected with one another with the superconductive state being maintained by a superconducting connection 43. The superconducting magnet 39 is cooled and kept at a low temperature by liquid helium stored in a liquid helium tank 44. The helium tank 44 is surrounded by a liquid nitrogen tank 45 to establish a dual structure of the helium tank 44 and the nitrogen tank 45, so that evaporation of the liquid helium is suppressed. The NMR apparatus as a whole is supported by vibration proof supports 46.

Next, Fig. 1 is a sectional view showing the superconducting magnet of the NMR apparatus according to the present invention, and Fig. 10 is a sectional perspective view of the superconducting coils. Each of the superconducting coils 1 to 5/1' to 5' is made from a material having a high superconducting critical magnetic field. The closer the coils are to a sample 7 (see Fig. 1), the higher the critical magnetic field. A sample 7 such as a protein sample is inserted from above to be placed upright at the center portion of the magnetic field, and the magnetic field is applied to the sample from the lateral directions. Each of the superconducting magnets consists of a pair of left and right coils which are arranged symmetrically, and each of the coils is wound about a horizontal axis in a solenoidal fashion. A solenoid coil 6 which is made from copper and maintained at an ordinary temperature or a solenoid coil 6 which is Y-based or made from $MgB_2$ and cooled to 10 to 20 K is used for the NMR signal detection. The superconducting magnets are set to a permanent current mode by a permanent current switch 10 (see Fig. 1), and the time fluctuation of the magnetic field is 0.5 Hz/h or less. The superconducting magnets are immersed in liquid helium 9 and maintained at a low temperature. The gap between the container containing the liquid helium 9 and the housing is filled with liquid nitrogen 8, so that the dual structure of the liquid helium 9 and the liquid nitrogen 8 contributes to conserving helium. The left and right superconducting coils of the present embodiment have central axes which are substantially concentric with each other in the horizontal direction and generate a horizontal magnetic field. The superconducting coils are arranged to be multilayered, i.e., are arranged radially and concentrically, and each of the left and right superconducting coils are substantially mirror-symmetrical with each other with respect to a centerplane extending along the vertical direction of the magnet device. The direction of the current flowing through the superconducting coils 5 and 5', which form the innermost layer together with the superconducting coils 4 and 4', is reverse to that of the currents of the other superconducting coils. More specifically, the direction of the magnetic field generated in the sample area by the superconducting coils 5 and 5' is reverse to the direction of the main magnetic field generated by the other superconducting coils. Owing to this structure, the split-type magnet device shown generates a remarkably uniform magnetic field whose uniformity is the same as or superior than that generated by conventional multilayer solenoids.

The foregoing is a summary of the NMR system using the magnet of the split-coil structure according to the present invention. Only the structure of the superconducting coils of the NMR system is described in each of the following embodiments.

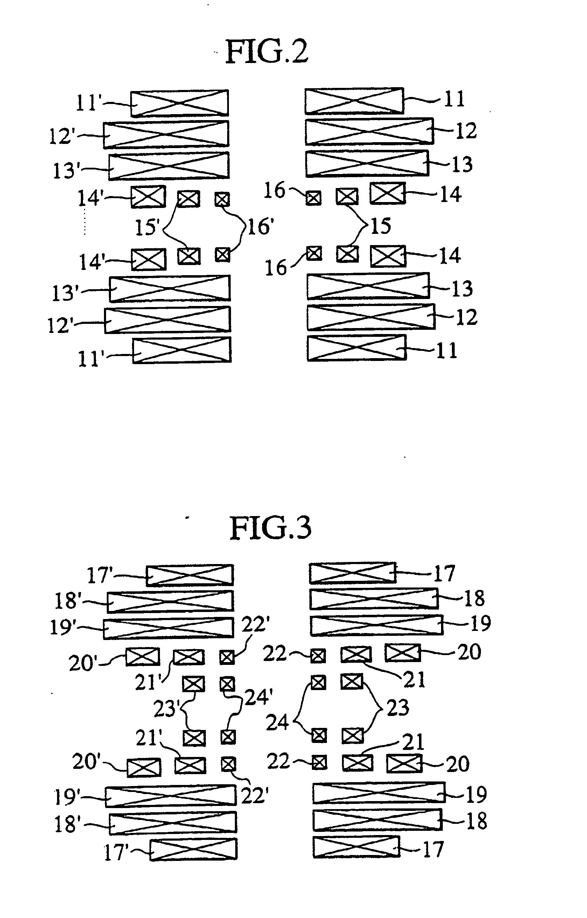

An arrangement of superconducting coils according to a second embodiment of the present invention is shown in Fig. 2. Each of the pairs of (left and right) superconducting coils 11 to 16 and 11' to 16' (for example, the pair of 11 and 11') is arranged substantially concentric with each other with respect to the central axis extending along the horizontal direction. The left and right multilayer superconducting coils are arranged substantially symmetrically with respect to the centerplane extending along the vertical direction of the magnet device, and a certain distance is kept between the centerplane and each of the multilayer superconducting coils, i.e. the two sets of superconductor coil elements. The superconducting coils 14, 14', 15' and 16, 16' form the innermost layer, wherein the superconducting coils 15 and 15' are energized in such a manner that the magnetic field generated thereby is in the direction reverse to that generated at the central part. Thus, a magnetic field of ppb-order uniformity is formed at the center portion of the split-type magnet device of the present embodiment.

An arrangement of superconducting coils according to a third embodiment of the present invention is shown in Fig. 3. Each of the pairs of (left and right) superconducting coils 17 to 24 and 17' to 24' (for example the pair of 17 and 17') is arranged substantially concentric with each other with respect to the central axis extending along the horizontal direction. The left and right multilayer superconducting coils, i.e. the left set and the right set of superconductor coil elements, are arranged substantially symmetrically with respect to the centerplane extending along the vertical direction of the magnet device, and a certain distance is kept between the centerline and each of the multilayer superconducting coils, i.e. the two sets of superconductor coil elements. Among the layers formed by the pairs of (left and right) superconducting coils, the innermost layers are formed of the superconducting coils 23, 23', 24 and 24' and layers disposed radially outward from the innermost layers are formed of the superconducting coils 20, 20', 21, 21', 22 and 22'. The pair of superconducting coils 22 and 22' and the pair of superconducting coils 23 and 23' are energized in such a manner as to generate a magnetic field which is in a direction reverse to that generated at the central part. Thus, a magnetic field of a ppb-order uniformity is formed at the center portion of the split-type magnet device of the present embodiment.

The NMR apparatus should desirably have a small leakage magnetic field and, therefore, a fourth embodiment which will hereinafter be described includes means for shielding the leakage magnetic field.

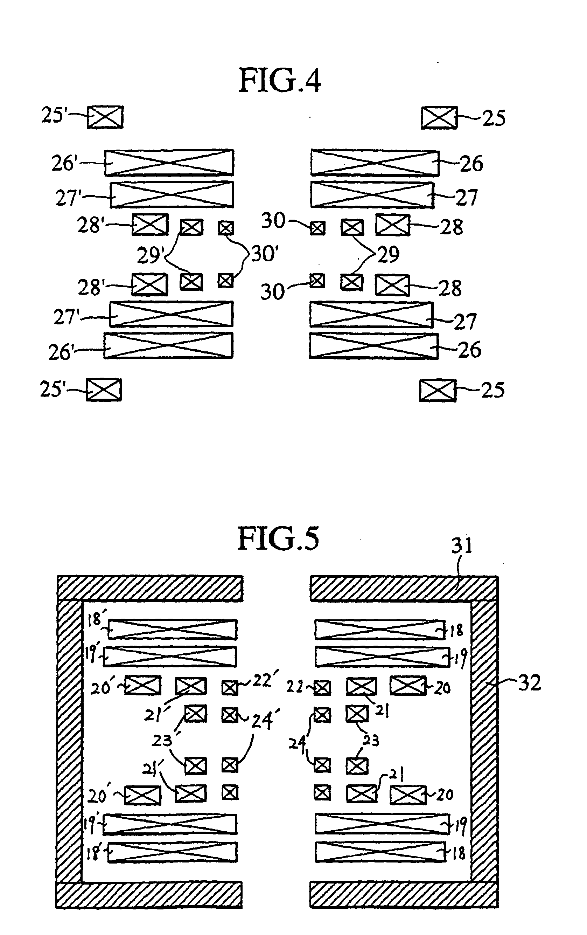

An arrangement of superconducting coils according to the fourth embodiment of the present invention is shown in Fig. 4. Superconducting coils 26 to 30 and 26' to 30' generate a uniform magnetic field at the center portion of the magnet device. In the present embodiment, the superconducting coil 30, 30' is energized to generate a magnetic field which is in a direction reverse to that generated by the other coils, so that a magnetic field of ppb-order uniformity is generated. Superconducting shielding coils 25 and 25' are active shielding coils used for suppressing the leakage of the magnetic field.

An arrangement of superconducting coils and a ferromagnetic member for shielding a leakage magnetic field according to a fifth embodiment of the present invention are shown in Fig. 5. A cylindrical ferromagnetic member 31 and a disk-like ferromagnetic member 32 form magnetic barriers to inhibit a magnetic field, which is generated by the superconducting coils, from leaking outside.

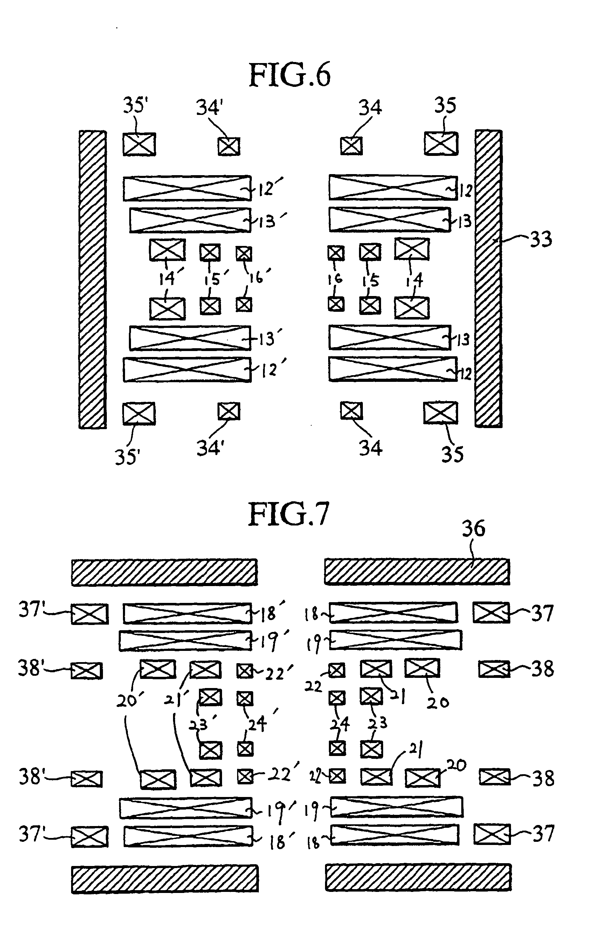

An arrangement of superconducting coils and a ferromagnetic member for shielding leakage magnetic field according to a sixth embodiment of the present invention are shown in Fig. 6. Superconducting shielding coils 34, 34' inhibit a magnetic field from leaking radially outward, while the disk-like ferromagnetic member 33 inhibits a magnetic field from leaking along the axial direction.

An arrangement of superconducting coils and a ferromagnetic member for shielding leakage magnetic field according to a seventh embodiment of the present invention are shown in Fig. 7. Superconducting shielding coils 37, 37' and 38, 38' inhibit the magnetic field from leaking along the axial direction, while a cylindrical ferromagnetic member 36 inhibits the magnetic field from leaking radially.

Although all the coils constituting the magnet device are superconducting coils through the foregoing embodiments, the present invention is not limited to the embodiments, and the coils may be those which can carry a current such as coils fabricated by winding a copper wire. Further, a permanent magnet may be used as a source of the magnetomotive force for the static magnetic field source.

Various embodiments of the present invention as defined in the independent claims are possible; however, the invention is not limited to the embodiments described in this specification.

According to the present invention, the NMR apparatus for solution analysis using the split-type magnet device can generate a magnetic field of ppb-order uniformity in the detection space. Since it is possible to insert a solenoid type probe coil into the magnetic field using a split gap of the magnet device, even an apparatus of 800 MHz can achieve a S/N detection sensitivity equivalent to that of a conventional 1 GHz NMR apparatus. Further, since the intensity at the center portion of the magnetic field is relatively low, it is possible to shield the leakage magnetic field, thereby remarkably improving the installability of the apparatus.

**Claims**

1. Split-type magnet device (39) for NMR spectrometers,

    - comprising a first set of superconductor coil elements (1, 2, 3, 4, 5) and a second set of superconductor coil elements (1', 2' 3', 4', 5'),

    wherein

    - the coil elements (1, 2, 3, 4, 5) of the first set of coil elements and the coil elements (1', 2', 3', 4', 5') of the second set of coil elements

        • each comprise at least one coil,
        • are arranged radially outward and substantially coaxially with respect to a central axis which extends along a substantially horizontal direction,
        • are arranged substantially mirror-symmetrically to one another with respect to a centerplane extending along the vertical direction of the magnet device (39) and face each other with a predetermined distance to form a sample space therebetween, and
        • are provided to generate a horizontal magnetic field,

    - the sample space between the first set of coil elements (1, 2, 3, 4, 5) and the second set of coil elements (1', 2', 3', 4', 5') is provided for placing a tube for a sample (7) in a vertical position at the center portion of the magnetic field and for placing a solenoid probe coil (6) around the tube for the sample (7), and

    - the direction of the magnetic field generated by the innermost coil element (4, 5) of the first set of coil elements and the innermost coil element (4', 5') of the second set of coil elements is reverse to the direction of the main magnetic field generated by the other coil elements (1, 2, 3) of the first set and the other coil elements (1', 2', 3') of the second set of coil elements in the vicinity of the center portion of the magnet device (39).

2. Magnet device (39) according to claim 1, **characterized in that** the innermost coil element of the first and the second set of coil elements is formed of a plurality of coils (4, 5/4', 5'; 14, 15, 16/14', 15', 16';

23, 24/23', 24'; 28, 29, 30/28', 29', 30').

3. Magnet device (39) according to claim 1 or 2, **characterized in that** only

    - the innermost coil element of the first and the second set of coil elements is formed of a plurality of coils (23, 24/23', 24'), and
    - a coil element or coil elements of the first and the second set of coil elements placed radially outward from the innermost coil element of the first and the second set of coil elements is/are formed of a plurality of coils (20, 21, 22/20', 21', 22').

4. Magnet device (39) according to any of claims 1 to 3, **characterized in that** superconducting shielding coils (25/25'; 34/34'; 37, 38/37', 38') or a ferromagnetic member (31, 32, 33; 36) for shielding the leakage magnetic field are provided.

5. Magnet device (39) according to claim 4, **characterized in that** it comprises a cylindrical ferromagnetic member (31; 36).

6. Magnet device (39) according to claim 4, **characterized in that** it comprises a disk-like ferromagnetic member (32; 33) and superconducting shielding coils (34, 35/34', 35').

7. Magnet device (39) according to any of claims 1 to 6, **characterized in that** it comprises means (44, 45) capable of cooling the coils to or below temperatures at which the coils exhibit superconductivity.

8. Magnet device (39) according to any of claims 1 to 7, **characterized in that** at least one coil element of the first and the second set of coil elements is replaced by one or more permanent magnets.

9. NMR spectrometer comprising the magnet device (39) according to any of claims 1 to 8.

**Patentansprüche**

1. Magnetvorrichtung (39) vom zweigeteilten Typ für NMR-Spektrometer,

    - die einen ersten Satz von Supraleiter-Spulenelementen (1, 2, 3, 4, 5) und einen zweiten Satz von Supraleiter-Spulenelementen (1', 2', 3', 4', 5') aufweist,

    wobei

    - die Spulenelemente (1, 2, 3, 4, 5) des ersten Satzes von Spulenelementen und die Spulenelemente (1', 2', 3', 4', 5') des zweiten Satzes von Spulenelementen

• jeweils aus mindestens einer Spule bestehen,
• in Radialrichtung nach außen und im Wesentlichen koaxial in Bezug auf eine zentrale Achse angeordnet sind, die sich längs einer im Wesentlichen horizontalen Richtung erstreckt,
• in Bezug auf eine Mittelebene, die sich längs der Vertikalrichtung der Magnetvorrichtung (39) erstreckt, im Wesentlichen spiegelsymmetrisch zueinander angeordnet sind und einander in einem vorgegebenen Abstand gegenüberliegen, wodurch ein Probenraum zwischen ihnen gebildet wird, und
• vorgesehen sind, um ein horizontales Magnetfeld zu erzeugen,

- der Probenraum zwischen dem ersten Satz von Spulenelementen (1, 2, 3, 4, 5) und dem zweiten Satz von Spulenelementen (1', 2', 3', 4', 5') dazu vorgesehen ist, ein Röhrchen für eine Probe (7) in einer senkrechten Richtung im zentralen Bereich des Magnetfeldes und eine Solenoid-Messspule (6) um das Röhrchen für die Probe (7) herum anzuordnen, und

- die Richtung des Magnetfeldes, das durch das innerste Spulenelement (4, 5) des ersten Satzes von Spulenelementen und durch das innerste Spulenelement (4', 5') des zweiten Satzes von Spulenelementen erzeugt wird, der Richtung des Hauptmagnetfeldes, das durch die anderen Spulenelemente (1, 2, 3) des ersten Satzes von Spulenelementen und durch die anderen Spulenelemente (1', 2', 3') des zweiten Satzes von Spulenelementen in der Nähe des zentralen Bereiches der Magnetvorrichtung (39) erzeugt wird, entgegengesetzt ist.

2. Magnetvorrichtung (39) nach Anspruch 1, **dadurch gekennzeichnet, dass** das innerste Spulenelement des ersten und des zweiten Satzes von Spulenelementen durch mehrere Spulen (4, 5/4', 5'; 14, 15, 16/14', 15', 16'; 23, 24/23', 24'; 28, 29, 30/28', 29', 30') gebildet wird.

3. Magnetvorrichtung (39) nach Anspruch 1 oder 2, **dadurch gekennzeichnet, dass** lediglich

- das innerste Spulenelement des ersten und des zweiten Satzes von Spulenelementen durch mehrere Spulen (23, 24/23', 24') gebildet wird und
- ein Spulenelement oder Spulenelemente des ersten und des zweiten Satzes von Spulenelementen, das/die in Radialrichtung vom innersten Spulenelement des ersten und des zweiten Satzes von Spulenelementen nach außen angeordnet ist/sind, durch mehrere Spulen (20, 21, 22/20', 21', 22') gebildet wird/werden.

4. Magnetvorrichtung (39) nach einem oder mehreren der Ansprüche 1 bis 3, **dadurch gekennzeichnet, dass** supraleitende Abschirmspulen (25/25'; 34/34'; 37, 38/37', 38') oder ein ferromagnetisches Element (31, 32; 33; 36) zur Abschirmung des magnetischen Streufeldes vorgesehen sind.

5. Magnetvorrichtung (39) nach Anspruch 4, **dadurch gekennzeichnet, dass** sie ein zylindrisches ferromagnetisches Element (31; 36) aufweist.

6. Magnetvorrichtung (39) nach Anspruch 4, **dadurch gekennzeichnet, dass** sie ein scheibenförmiges ferromagnetisches Element (32; 33) und supraleitende Abschirmspulen (34, 35/34', 35') aufweist.

7. Magnetvorrichtung (39) nach einem oder mehreren der Ansprüche 1 bis 6, **dadurch gekennzeichnet, dass** sie eine Einrichtung (44, 45) aufweist, die in der Lage ist, die Spulen auf oder unter Temperaturen abzukühlen, bei denen die Spulen Supraleitung zeigen.

8. Magnetvorrichtung (39) nach einem oder mehreren der Ansprüche 1 bis 7, **dadurch gekennzeichnet, dass** mindestens ein Spulenelement des ersten und des zweiten Satzes von Spulenelementen durch einen oder mehrere Permanentmagnete ersetzt ist.

9. NMR-Spektrometer, das die Magnetvorrichtung (39) nach einem oder mehreren der Ansprüche 1 bis 8 aufweist.

**Revendications**

1. Dispositif magnétique du type divisé (39) pour spectromètres de résonance magnétique nucléaire,

- comprenant un premier ensemble d'éléments de bobine supraconducteurs (1, 2, 3, 4, 5) et un deuxième ensemble d'éléments de bobine supraconducteurs (1', 2', 3', 4', 5'),

dans lequel

- les éléments de bobine (1, 2, 3, 4, 5) du premier ensemble d'éléments de bobine et les éléments de bobine (1', 2', 3', 4', 5') du deuxième ensemble d'éléments de bobine

• comprennent chacun au moins une bobine,

• sont disposés de manière radiale vers l'extérieur et de manière sensiblement coaxiale par rapport à un axe central qui s'étend le long d'une direction sensiblement horizontale,

• sont disposés de manière à être sensiblement symétriques les uns des autres par rapport à un plan médian s'étendant le long de la direction verticale du dispositif magnétique (39) et se font face à une distance prédéterminée pour former un espace pour échantillon entre les deux,

et

• sont fournis pour produire un champ magnétique horizontal,

- l'espace pour échantillon entre le premier ensemble d'éléments de bobine (1, 2, 3, 4, 5) et le deuxième ensemble d'éléments de bobine (1', 2', 3', 4', 5') est prévu pour placer un tube à échantillon (7) dans une position verticale dans la partie centrale du champ magnétique et pour placer une bobine-sonde de solénoïde (6) autour du tube à échantillon (7),

et

- la direction du champ magnétique produit par l'élément de bobine le plus au centre (4, 5) du premier ensemble d'éléments de bobine et par l'élément de bobine le plus au centre (4', 5') du deuxième ensemble d'éléments de bobine est opposée à la direction du champ magnétique principal produit par les autres éléments de bobine (1, 2, 3) du premier ensemble et les autres éléments de bobine (1', 2', 3') du deuxième ensemble d'éléments de bobine à proximité de la partie centrale du dispositif magnétique (39).

2. Dispositif magnétique (39) selon la revendication 1, **caractérisé en ce que** l'élément de bobine le plus au centre du premier ensemble et du deuxième ensemble d'éléments de bobine est constitué d'une pluralité de bobines (4, 5/4', 5' ; 14, 15, 16/14', 15', 16' ; 23, 24/23', 24' ; 28, 29, 30/28', 29', 30').

3. Dispositif magnétique (39) selon la revendication 1 ou 2,
**caractérisé en ce que** seulement

- l'élément de bobine le plus au centre du premier ensemble et du deuxième ensemble d'éléments de bobine est constitué d'une pluralité de bobines (23, 24/23', 24'),
et
- un élément de bobine ou des éléments de bobine du premier ensemble et du deuxième ensemble d'éléments de bobine placés de manière radiale vers l'extérieur de l'élément de bobine le plus au centre du premier ensemble et du deuxième ensemble d'éléments de bobine est/sont constitué/s d'une pluralité de bobines (20, 21, 22/20', 21', 22').

4. Dispositif magnétique (39) selon l'une quelconque des revendications 1 à 3, **caractérisé en ce que** les bobines de blindage supraconductrices (25/25' ; 34/34' ; 37, 38/37', 38') ou un élément ferromagnétique (31, 32 ; 33 ; 36) permettant de faire écran au champ magnétique de fuite sont fournis.

5. Dispositif magnétique (39) selon la revendication 4, **caractérisé en ce qu'**il comprend un élément ferromagnétique cylindrique (31 ; 36).

6. Dispositif magnétique (39) selon la revendication 4, **caractérisé en ce qu'**il comprend un élément ferromagnétique en forme de disque (32 ; 33) et des bobines de blindage supraconductrices (34, 35/34', 35').

7. Dispositif magnétique (39) selon l'une quelconque des revendications 1 à 6, **caractérisé en ce qu'**il comprend des moyens (44, 45) capables de refroidir les bobines à des températures ou en dessous de températures auxquelles les bobines présentent une supraconductivité.

8. Dispositif magnétique (39) selon l'une quelconque des revendications 1 à 7, **caractérisé en ce qu'**au moins un élément de bobine du premier ensemble et du deuxième ensemble d'éléments de bobine est remplacé par un ou plusieurs aimants permanents.

9. Spectromètre de résonance magnétique nucléaire comprenant le dispositif magnétique (39) selon l'une quelconque des revendications 1 à 8.

# FIG.1

# FIG.2

11' — [×]
12' — [×]
13' — [×]
14' — [×] [×] [×]    16 — [×] [×] [×] — 14
15' [×]    16'    15    16
14' — [×] [×] [×]    [×] [×] [×] — 14
13' — [×]    16 — [×]    13
12' — [×]    12
11' — [×]    11

11 — [×]
12 — [×]
13 — [×]

# FIG.3

17' — [×]    17 — [×]
18' — [×]    18 — [×]
19' — [×] 22'    19 — [×]
20' — [×] [×] [×]    22 — [×] [×] [×] — 20
21' [×] [×] 24'    22 — [×] [×] — 21
23' [×] [×]    24    23
21' — [×] [×]    [×] [×] — 21
20' — [×] [×] [×]    22 — [×] [×] [×] — 20
19' — [×] 22'    19 — [×]
18' — [×]    18 — [×]
17' — [×]    17 — [×]

# FIG.4

25' — ⊠                                    ⊠ — 25

26' — [⊠]                                  [⊠] — 26

27' — [⊠]                                  [⊠] — 27

28' — [⊠] [⊠] [⊠]        30 — ⊠ [⊠] [⊠] — 28

29' ⏜ ⏜ 30'              29

28' — [⊠] [⊠] [⊠]        30 — ⊠ [⊠] [⊠] — 28

27' — [⊠]                                  [⊠] — 27

26' — [⊠]                                  [⊠] — 26

25' — ⊠                                    ⊠ — 25

# FIG.5

31

18' — [⊠]                                  [⊠] — 18

19' — [⊠]                                  [⊠] — 19

20' — [⊠] [⊠] [⊠]~22'    22'~⊠ [⊠] [⊠] — 20        32

21' ⊠ ⊠~24'              ⊠ [⊠] — 21

23' ⏜ ⏜ ⊠               24 ⏜ ⏜ 23

21' ⊠ ⊠                  ⊠ [⊠] — 21

20' — [⊠] [⊠] [⊠]        ⊠ [⊠] [⊠] — 20

19' — [⊠]                                  [⊠] — 19

18' — [⊠]                                  [⊠] — 18

# FIG.6

# FIG.7

# FIG.8

# FIG.9

# FIG.10

# FIG.11

## FIG.12

## FIG.13

## FIG.14

## FIG.15

## FIG.16

**EP 1 361 453 B1**

**REFERENCES CITED IN THE DESCRIPTION**

**Patent documents cited in the description**

- US 6121776 A
- JP 2000266830 A
- JP 6237912 A
- JP 2000147082 A

- JP 11248810 A
- JP 7240310 A
- EP 1004887 A
- JP 2002043116 A

**Non-patent literature cited in the description**

- *IEEE. Transactions on Applied Superconductivity,* vol. 11 (1), 2438